# EUROPÄISCHE PATENTSCHRIFT

(11) **EP 2 271 787 B1**
(45) Veröffentlichungstag und Bekanntmachung des Hinweises auf die Patenterteilung: **21.08.2013**
(21) Anmeldenummer: 09727416.1
(22) Anmeldetag: 11.03.2009
(51) Int. Cl.: C23C 14/24

(54) **VERDAMPFERKÖRPER**
EVAPORATOR BODY
CORPS ÉVAPORATEUR

(30) Priorität: 01.04.2008 DE 102008016619
(43) Veröffentlichungstag der Anmeldung: 12.01.2011
(73) Patentinhaber: Kennametal Sintec Keramik GmbH, 86956 Schongau (DE)
(72) Erfinder: NÜRNBERGER, Michael, 93055 Regensburg (DE); GRAU, Rudolf, 91413 Neustadt a. d. Aisch (DE); SCHWEIGER, Hubert, 87629 Füssen (DE)
(74) Vertreter: Freier, Rüdiger
(86) Internationale Anmeldenummer: PCT/EP2009/052876
(87) Internationale Veröffentlichungsnummer: WO 2009/121700

(56) Entgegenhaltungen:
- EP-A- 1 683 886
- DE-A1- 1 771 968
- DE-A1-102005 057 220
- DE-C1- 4 128 382
- US-A- 3 725 045

## Beschreibung

Die Erfindung betrifft einen Verdampferkörper.

Das gebräuchliche Verfahren zum Beschichten von flexiblen Substraten mit Metallen ist das sog. Vakuum-Bandmetallisieren gemäß der PVD (physical vapor deposition)-Technik. Als flexible Substrate kommen z.B. Papier, Kunststofffolien und Textilien in Frage, und als Metall wird überwiegend Aluminium eingesetzt. So beschichtete Substrate finden breite Anwendung für Verpackungs- und Dekorationszwecke, bei der Kondensatorherstellung und in der Umwelttechnik (Isolation).

Die Beschichtung der flexiblen Substrate erfolgt in sog. Metallisierungsanlagen. In der Metallisierungsanlage wird das zu beschichtende Substrat über eine gekühlte Walze geführt und dabei Metalldampf ausgesetzt, der sich auf der Substratoberfläche als dünne Metallschicht niederschlägt. Zur Erzeugung des erforderlichen Metalldampfstromes werden widerstandsbeheizbare Verdampferkörper, z.B. in Form sogenannter Verdampferschiffchen, eingesetzt, die im direkten Stromdurchgang auf z.B. 1450-1600°C erhitzt werden. Metalldraht wird der Verdampfungsfläche (in der Regel ist dies die Oberseite des Verdampferkörpers) zugeführt, auf der Verdampfungsfläche verflüssigt und im Vakuum bei ca. 10⁻⁴ mbar verdampft.

Nicht flexible Substrate werden gemäß der PVD-Technik z.B. batchweise in einem diskontinuierlichen Prozess, z.B. mittels Flash-Verdampfung, beschichtet. Nicht flexible Substrate sind z.B. Fernsehbildschirme und Kunststoffteile.

Herkömmliche Verdampferkörper bestehen z.B. aus heißgepreßtem keramischem Material, das als Hauptkomponenten Titandiborid und Bornitrid und/oder Aluminiumnitrid enthält. Titandiborid ist dabei die elektrisch leitfähige Komponente und Bornitrid und/oder Aluminiumnitrid sind die elektrisch isolierende Komponente, die miteinander gemischt zu spezifischen elektrischen Heißwiderständen von 600-6000 µOhm*cm führen, wobei ein Mischungsverhältnis von leitfähiger zu nichtleitfähiger Komponente von je 50 Gew.-% (+/- 10 Gew.-%) vorliegt.

Ein in der Praxis häufig auftretendes Problem stellt die Benetzung, vor allem die Erstbenetzung zu Beginn des Metallisierungsprozesses, der Verdampfungsfläche des Verdampferkörpers mit dem zu verdampfenden Metall dar. Dies führt dazu, dass aufgrund der geringeren Benetzungsfläche zu Beginn des Metallisierungsprozesses nur verminderte Abdampfraten (Kilogramm Metall/Zeiteinheit) realisiert werden können. Ferner besteht bei einer ungleichmäßigen und unvollständigen Benetzung der Verdampfungsfläche das Problem, dass sich die Leitfähigkeit des insgesamt leitfähigen Verdampferkörpers durch das damit in Kontakt stehende, zu verdampfende Metall ändert (Parallelwiderstand), und zwar unregelmäßig je nach Menge und Ausdehnung an zugeführtem und abgedampftem Metall. Hierdurch ist es notwendig, die Stromzufuhr an den Verdampferkörper stets entsprechend nachzuregeln, um eine gleichmäßige Abdampfrate beibehalten zu können.

Daher wird im Stand der Technik auf die die Verdampfungsfläche bildende Oberfläche des Verdampferkörpers häufig eine Schichtstruktur aufgebracht, um die Benetzbarkeit mit dem zu verdampfenden Metall zu verbessern.

Zudem sind zweiteilige Verdampferschiffchen mit einem elektrisch leitfähigen Verdampferkörper-Kernteil und einem elektrisch isolierenden Verdampferkörper-Außenteil bekannt, welches das Kernteil aufnimmt/umhüllt, wobei das Verdampferkörper-Außenteil aus einem benetzungsfördernden Material hergestellt ist.

Des Weiteren ist aus der EP 1 688 514 A1 ein keramisches Verdampferschiffchen bekannt, dessen Verdampfungsfläche mit einer Mehrzahl von Nuten/Rillen versehen ist. Die Nuten sind derart angeordnet, dass sie nicht parallel zur Stromflussrichtung sind, d.h. geneigt sind zur Längsachse des Verdampferschiffchens. Die Nuten haben eine Breite von 0,1 bis 1,5 mm, eine Tiefe von 0,03 bis 1 mm und eine Länge von mindestens 1 mm. Die Nuten sollen im Verdampfungsbetrieb eine verbesserte Benetzung mit dem flüssigen Aluminium bewirken. Insbesondere soll gemäß der EP 1 688 514 A1 durch die Nuten die Benetzung in Verdampferkörper-Längsrichtung unterdrückt/reduziert werden und die Benetzung in Verdampferkörper-Querrichtung gefördert werden, d.h. durch die Nuten soll eine breitere Benetzung der Verdampferfläche erzielt werden. Dies wird überwiegend durch die zwei folgenden Effekte bewirkt. Zum einen wird durch die geringe Breite der Nuten eine Art Kapillareffekt erzielt, der dafür sorgt, dass in den Nuten befindliches flüssiges Aluminium zu den Nut-Längsenden hin "gezogen" wird. Zum anderen erhöht sich durch Reflektion der Wärmestrahlung an den Seitenwänden der Nuten die Temperatur innerhalb der Nuten. Eine erhöhte Temperatur verringert den Benetzungswinkel, so dass das Metall besser benetzt.

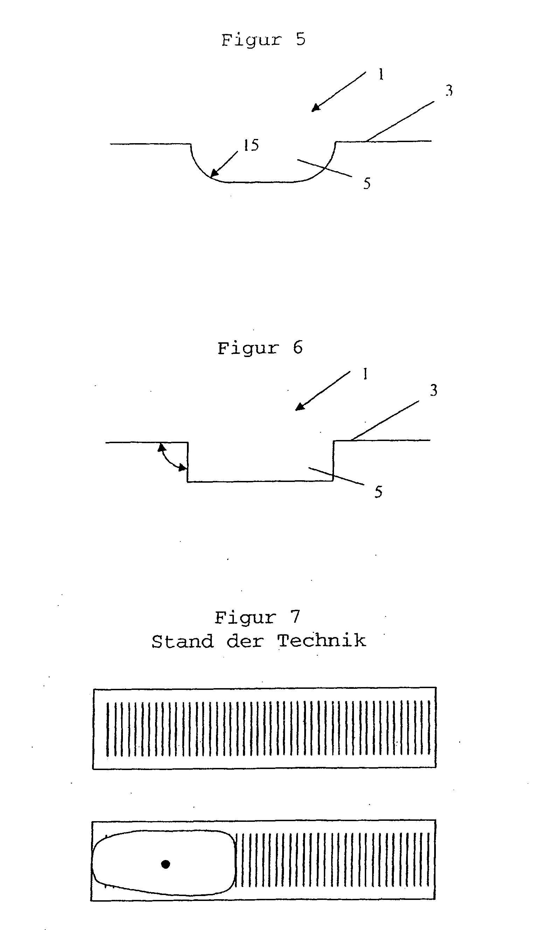

Ein solches Verdampferschiffchen gemäß dem Stand der Technik ist in Figur 7 gezeigt, wobei die Nuten als Querrillen ausgebildet sind.

Diese bekannten Verdampferschiffchen haben den Nachteil, dass ihre Herstellung aufwendig ist, da eine große Anzahl von relativ dünnen Nuten auf der Verdampfungsfläche vorgesehen werden muss. Ein weiterer Nachteil besteht darin, dass sich das Metallbad bzw. die Metallschmelze nur dann gleichmäßig in Verdampferschiffchen-Längsrichtung ausbildet/ausdehnt, wenn der Metalldraht in Längsrichtung mittig zugeführt wird. Dies liegt daran, dass sich das Metallbad ausgehend vom Metalldrahtauftreffpunkt nach beiden Seiten hin mit gleicher Längenausbreitung ausdehnt. Wie in Figur 7 gezeigt, benetzt das Metall die Verdampfungsfläche des Verdampferschiffchens unvollständig (vor allem in Längsrichtung), wenn der Metalldrahtauftreffpunkt dezentral gelegen ist. Ein solches einseitiges Benetzen führt dazu, dass das Metallbad auf einer der Längsseiten auf die wassergekühlte Kupfereinspannung läuft und die gegenüberliegende Seite unbenetzt bleibt. Die gegenüberliegende Seite überhitzt nun, da die Kühlwirkung der flüssigen Metallschmelze fehlt.

Aus DE 20 2005 020 544 U1 ist eine verdampfervorrichtung bekannt, enthaltend einen Tiegel mit einer Einschmelzzone und einer mit der Einschmelzzone in Verbindung stehenden Verdampferzone.

DE 10 2005 057 220 A1 offenbart einen Behälter zur Verdampfung von Metall, wobei an dem Boden der Verdampfungsfläche eine Mehrzahl von Nuten ausgebildet ist.

Es ist eine Aufgabe der Erfindung, einen möglichst unempfindlichen und einfach zu bedienenden verdampferkörper bereitzustellen, der unabhängig vom Metalldrahtauftreffpunkt bzw. unabhängig vom Ort der Metallzuführung eine zweckmäßige (d.h. im Wesentlichen gleichmäßige und vollständige) Benetzung der Verdampfungsfläche mit dem Metall sowohl in Breiten- als auch in Längsrichtung des Verdampferkörpers ermöglicht. Zudem soll der Verdampferkörper einfach und kostengünstig herstellbar sein.

Hierzu stellt die Erfindung einen Verdampferkörper nach Anspruch 1 bereit. Weitere Ausführungsformen des erfindungsgemäßen Verdampferkörpers sind in den abhängigen Ansprüchen beschrieben.

Der erfindungsgemäße Verdampferkörper weist eine Verdampfungsfläche auf, von der aus zugeführtes Metall verdampft werden kann. Zum Beispiel kann der Verdampfungsfläche Metall wie z.B. Aluminium in Form eines Metalldrahts zugeführt werden. Alternativ/Zusätzlich ist es möglich, der Verdampfungsfläche bereits geschmolzenes Metall zuzuführen. Im Falle des Metalldrahts wird das der Verdampfungsfläche zugeführte Metall zunächst auf der heißen Verdampfungsfläche verflüssigt/geschmolzen und anschließend verdampft.

Erfindungsgemäß weist die Verdampfungsfläche eine Mehrzahl von Vertiefungen auf, zum Beispiel zwei bis fünf Vertiefungen. Jede der Vertiefungen weist eine Öffnung mit einem Fläche/Umfang-Verhältnis von größer gleich.1,5 mm auf, z.B. größer gleich 2 mm, z.B. größer gleich 3 mm. Ist z.B. eine Vertiefung mit einer kreisförmigen Öffnung vorgesehen, so beträgt der Radius der Öffnung mindestens 3 mm. Ist z.B. eine Vertiefung mit einer kreisringförmigen Öffnung vorgesehen, so beträgt die Ringbreite der Öffnung mindestens 3 mm. Ist z.B. eine Vertiefung mit einer quadratischen Öffnung vorgesehen, so beträgt die Seitenlänge der Öffnung mindestens 6 mm.

Die Vertiefungen haben eine benetzungsfördernde Wirkung, die primär auf einer Änderung des Benetzungswinkels an der Kante zwischen Vertiefungs-Seitenwand und angrenzendem Teil der Verdampfungsfläche beruht. An dieser Kante staut sich das flüssige Metall auf und fließt entlang der Kante um die Öffnung herum, so dass das die Metallschmelze die Verdampfungsfläche zunächst primär entlang der Kante benetzt. Die Benetzung der Vertiefung durch "überhängendes" aufgestautes Metall erfolgt im Wesentlichen schlagartig. Das Fläche/Umfang-Verhältnis von größer gleich 1,5 mm begünstigt hierbei eine Benetzung der Verdampfungsfläche sowohl in Längen- als auch in Querrichtung des Verdampferkörpers. Des Weiteren hat sich herausgestellt, dass mit solchen Vertiefungen selbst dann eine gleichmäßige und großflächige Benetzung der Verdampfungsoberfläche erreicht werden kann, wenn die Metallzufuhr dezentral erfolgt, so dass ein Überlaufen der Metallschmelze vermieden wird. Das heißt, das flüssige Metall benetzt auch dann im Wesentlichen über die gesamte Verdampfungsfläche, wenn der Metalldrahtauftreffpunkt nicht mittig zu der Verdampfungsfläche ist. Der Verdampferkörper ist dadurch benutzerfreundlich und unempfindlich im Praxiseinsatz. Zudem sind die Vertiefungen einfach herzustellen/auszubilden.

Zum Beispiel kann auf der Verdampfungsfläche eine Kavität ausgebildet sein, in/auf deren Bodenfläche die Mehrzahl von Vertiefungen ausgebildet ist. Die Kavität bildet dabei eine Begrenzung für die Metallschmelze und verhindert ein seitliches Herunterlaufen der Metallschmelze.

Die Vertiefungen können zum Beispiel eine Tiefe von 0,05 bis 1 mm aufweisen. Zum Beispiel weisen die Vertiefungen eine Tiefe von 0,15 bis 0,4 mm auf.

Die Seitenwand der jeweiligen Vertiefung kann mit dem an die Vertiefung angrenzenden Teil der Verdampfungsfläche zum Beispiel einen Winkel von 80 bis 150° ausbilden. Die Benetzungswinkeländerung für das flüssige Metall an der Kante ist dann (180-80)°=100° bis (180-150)°=30°. Zum Beispiel kann der Winkel in dem Bereich von 90 bis 135° liegen, zum Beispiel in dem Bereich von 90 bis 120°. Dabei kann der Winkel z.B. derart gewählt sein, dass ein Aufstauen der Metallschmelze an der Kante zwischen Seitenwand und angrenzendem Teil der Verdampfungsfläche begünstigt ist, d.h. ein Hineinlaufen der Metallschmelze in die Vertiefung erschwert ist, so dass im Betrieb des Verdampferkörpers die Metallschmelze zunächst hauptsächlich entlang der durch die Seitenwand und den an diese angrenzenden Teil der Verdampfungsfläche gebildeten Kante (im folgenden Oberkante der Vertiefung genannt) um die Vertiefung herum fließt.

Die Seitenwand der jeweiligen Vertiefung kann zum Beispiel teilweise/abschnittsweise oder durchgehend gekrümmt sein, z.B. zumindest in dem an die Bodenfläche der Vertiefung angrenzenden Bereich, d.h. in dem Bereich der Kante zwischen Bodenfläche und Seitenwand der Vertiefung. Dadurch kann das Auftreten von Heißstellen im Betrieb des Verdampferkörpers vermieden werden. Werden die Vertiefungen durch Fräsen erzeugt, so kann zum Beispiel ein entsprechender Fräser mit Eckenradius verwendet werden. Zum Beispiel kann die Krümmung einen Radius von 0,05 bis 3 mm aufweisen, zum Beispiel einen Radius von 0,1 bis 1 mm, zum Beispiel 0,3 bis 0,5 mm.

Die Vertiefungen können zum Beispiel alle die gleiche Form aufweisen. Alternativ können die Vertiefungen aber auch unterschiedliche Formen aufweisen. Zum Beispiel können eine oder mehrere oder alle der Öffnungen kreisförmig oder kreisringförmig ausgebildet sein. Zum Beispiel können eine oder mehrere oder alle der Öffnungen die Form einer Ellipse oder eines Ellipsenrings haben. Zum Beispiel können eine oder mehrere oder alle der Öffnungen die Form eines gleichseitigen Vierecks (z.B. eines Quadrats) oder eines gleichseitigen Viereckrings haben, wobei zwei der Eckpunkte auf der Längsachse des Verdampferkörpers angeordnet sind, so dass eine Rautenform entsteht. Zum Beispiel können eine oder mehrere oder alle der Öffnungen die Form eines gleichschenkligen Dreiecks oder Dreieckrings haben, wobei die Hypotenuse des jeweiligen Dreiecks/Dreieckrings senkrecht zur Verdampferkörper-Längsachse angeordnet ist.

Die Mehrzahl von Vertiefungen kann zum Beispiel in Verdampferkörper-Längsrichtung hintereinander angeordnet sein. Zum Beispiel können die einzelnen Vertiefungen dabei mit Abstand zueinander angeordnet sein. Der Abstand zwischen den einzelnen Vertiefungen kann zum Beispiel 1 bis 80 mm, zum Beispiel 2 bis 10 mm, zum Beispiel 3 bis 8 mm betragen. Der Abstand zwischen den einzelnen Vertiefungen kann variieren oder konstant sein. Die einzelnen Vertiefungen können entweder voneinander getrennt/isoliert sein oder über einen Verbindungskanal miteinander in Verbindung stehen. Die einzelnen Vertiefungen können jedoch unter Ausbildung einer Einschnürung auch aneinander angrenzen oder sich teilweise überlappen. Die einzelnen Vertiefungen können in Verdampferkörper-Querrichtung im Wesentlichen mittig d.h. auf der Längsachse/Symmetrieachse des Verdampferkörpers angeordnet sein. Jedoch können die Vertiefungen auch zur Längsachse/Symmetrieachse des Verdampferkörpers versetzt angeordnet sein. Ferner können mehrere Vertiefungen in Verdampferkörper-Querrichtung hintereinander angeordnet sein.

Der Verdampferkörper kann zum Beispiel als elektrisch isolierendes Verdampferkörper-Außenteil ausgebildet sein, das einen inneren Hohlraum zur Aufnahme eines elektrisch leitfähigen widerstandsbeheizbaren Verdampferkörper-Kernteils aufweist. Das Außenteil wird dabei über das eingeschobene/eingesteckte Kernteil geheizt. Alternativ kann der Verdampferkörper aber auch einstückig als elektrisch leitfähiger widerstandsbeheizbarer Verdampferkörper ausgebildet sein. In beiden Fällen kann die Verdampfungsfläche des Verdampferkörpers zudem mit einer benetzungsfördernden Schicht/Beschichtung versehen werden. Eine solche Beschichtung kann auch dem Schutz vor Abnutzung und Korrosion dienen.

Die Vertiefungen lassen sich zum Beispiel durch Fräsen herstellen. Somit kann ein bestehender verdampferkörper einfach und kostengünstig unter Erzeugung des erfindungsgemäßen Verdampferkörpers nachbearbeitet/umgerüstet werden. Wird der Verdampferkörper durch Sintern eines Grünlings hergestellt, so können die Vertiefungen auch während des Formens des Grünlings ausgebildet werden, z.B. durch entsprechendes Eindrücken der Grünlingsmasse. Hierdurch kann die Nachbearbeitung des Verdampferkörpers mit einem Fräser oder ähnlichen Werkzeugen erleichtert werden oder gar völlig entfallen.

Die Erfindung wird im Folgenden anhand exemplarischer Ausführungsformen mit Bezugnahme auf die Zeichnung erläutert. In der Zeichnung zeigen:
Figur la eine Draufsicht auf einen Verdampferkörper gemäß einer ersten Ausführungsform der Erfindung,
Figur 1b eine schematische Draufsicht auf den Verdampferkörper aus Figur 1a während des Betriebs des Verdampferkörpers,
Figur 1c eine weitere Draufsicht auf den Verdampferkörper aus Figur 1a,
Figur 1d eine schematische Detailansicht des Verdampferkörpers aus Figur 1a während des Betriebs des Verdampferkörpers,
Figur 2 eine Draufsicht auf einen Verdampferkörper gemäß einer zweiten Ausführungsform der Erfindung,
Figur 3 eine Draufsicht auf einen Verdampferkörper gemäß einer dritten Ausführungsform der Erfindung,
Figur 4 zeigt Draufsichten auf weitere erfindungsgemäße Verdampferkörper,
Figur 5 und Figur 6 jeweils eine Detailansicht einer Vertiefung eines erfindungsgemäßen Verdampferkörpers und
Figur 7 einen Verdampferkörper gemäß dem Stand der Technik.

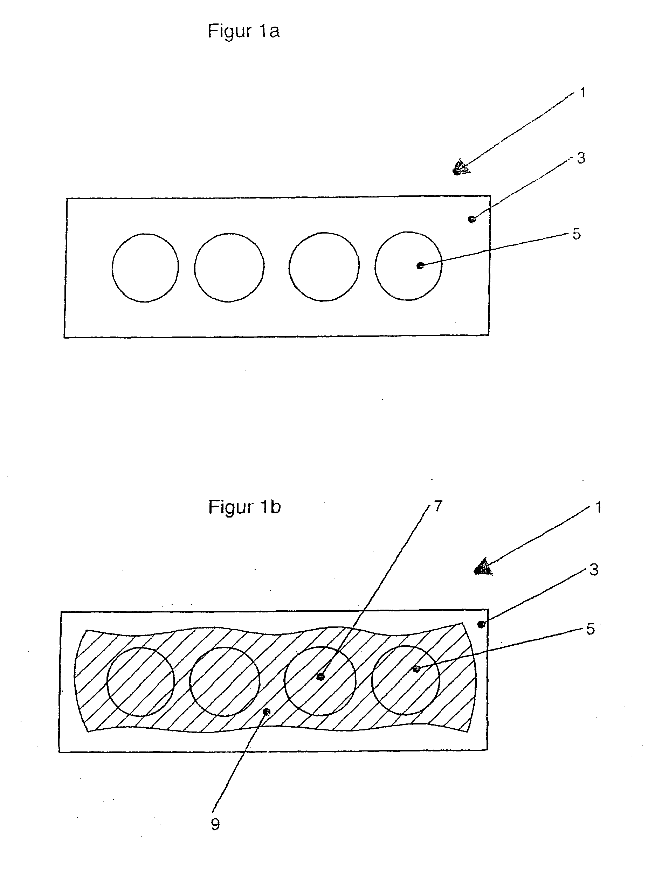

Figur 1a zeigt eine Draufsicht auf einen Verdampferkörper gemäß einer ersten Ausführungsform der Erfindung. Der Verdampferkörper 1 ist in Form eines sog. Verdampferschiffchens ausgebildet und besteht aus heißgepreßtem keramischem Material, das als Hauptkomponenten Titandiborid und Bornitrid enthält, wobei Titandiborid die elektrisch leitfähige Komponente und Bornitrid die elektrisch isolierende Komponente ist. Das Mischungsverhältnis von leitfähiger zu nichtleitfähiger Komponente liegt bei je 50% (+/- 10%), woraus sich ein spezifischer Widerstand von ca. 600-6000µOhm*cm ergibt. Der Verdampferkörper 1 ist als Plattenkörper ausgebildet, mit einer Länge von ca. 120 mm, einer Breite von ca. 35 mm und einer Höhe von ca. 10 mm. In der durch die Plattenoberseite gebildeten Verdampfungsfläche 3 des Verdampferkörpers 1 sind vier zylindrische Vertiefungen 5 ausgebildet, die z.B. mit einem entsprechenden Fräser geformt werden können. Das heißt, gemäß dieser Ausführungsform weist jede Vertiefung 5 eine kreisförmige Öffnung und eine kreisförmige Bodenfläche auf. Die Vertiefungen 5 sind in Verdampferkörper-Längsrichtung hintereinander angeordnet und voneinander getrennt. Der Abstand zwischen den einzelnen Vertiefungen 5 beträgt gemäß dieser Ausführungsform ca. 5 mm, die jeweilige Tiefe ca. 0,3 mm. Der Durchmesser der kreisförmigen Öffnung und der kreisförmigen Bodenfläche einer jeden Vertiefung beträgt ca. 20 mm. Somit ergibt sich jeweils ein Flächen/Umfang-Verhältnis (=r/2 bzw. d/4 für kreisförmige Öffnungen) von 5 mm.

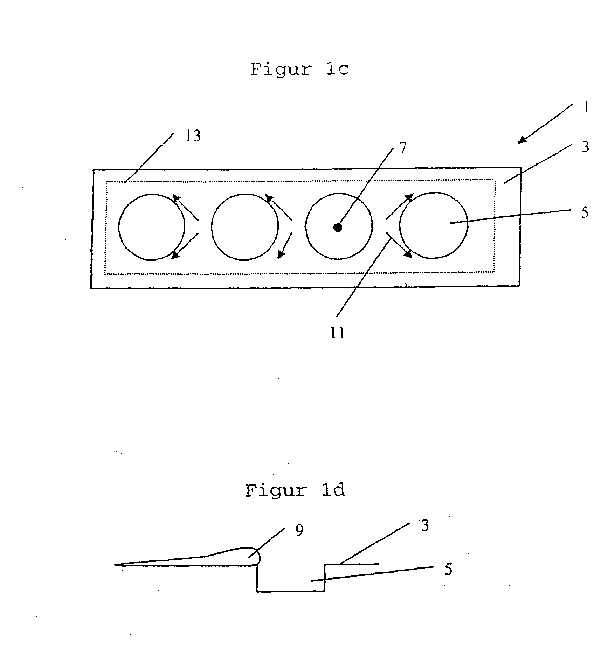

Figur 1b zeigt schematisch den Verdampferkörper 1 aus Figur 1a im Betrieb. Die Metalldrahtzufuhr/Aluminiumzufuhr auf die Verdampfungsfläche 3 erfolgte dezentral, nämlich an der zweiten Vertiefung 5 von rechts, wie durch Bezugszeichen 7 verdeutlicht. Dennoch konnte ein Metallbad 9 erzeugt werden, das im Wesentlichen die gesamte Verdampfungsfläche 3 gleichmäßig benetzt/bedeckt ohne überzulaufen. Bei genauer Betrachtung konnte man dabei erkennen, wie das flüssige Aluminium entlang des jeweiligen Öffnungsumfangs (=Kante zwischen Seitenwand der Vertiefung 5 und angrenzender Verdampfungsfläche 3) verteilt wurde (siehe z.B. zweite Vertiefung von links - rechte Seite). Der hierfür verantwortliche Effekt ist in den Figuren 1c und 1d verdeutlicht. Wie in Figur 1d gezeigt, staut sich die Metallschmelze 9 zunächst an der Oberkante der Vertiefung 5 auf. Dies ist auf eine Änderung des Benetzungswinkels um 90° an der Oberkante der Vertiefung 5 zurückzuführen. Dadurch benetzt die Metallschmelze 9 die Verdampfungsfläche 3 zunächst primär entlang der Oberkante der Vertiefung 5, wie durch die Pfeile 11 in Figur 1c angedeutet. Die Kreisform der vertiefungen 5 trägt dabei zu einer besonders günstigen Verteilung der Aluminiumschmelze 9 auf der Verdampfungsfläche 3 bei. Schließlich werden auch die Vertiefungen 5 bzw. deren Bodenfläche durch die Metallschmelze 9 bzw. aufgestautes Aluminium benetzt.

Wie durch die gestrichelte Linie in Figur 1c angedeutet, kann auf der Verdampfungsfläche 3 optional eine Kavität 13 ausgebildet sein, in/auf deren Bodenfläche die vier Vertiefungen 5 ausgebildet sind. Die Seitenwand der Kavität 13 bildet eine Barriere für die Metallschmelze, wodurch ein Überlaufen der Metallschmelze 9 verhindert wird.

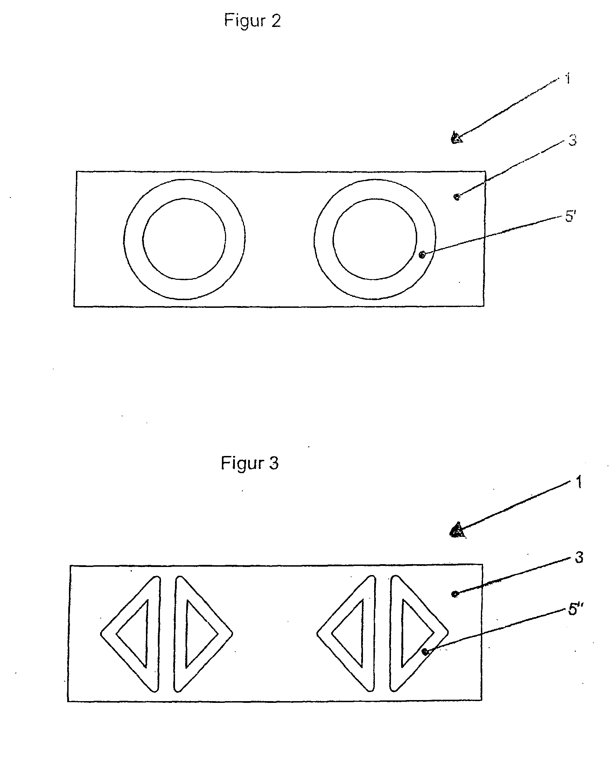

Figur 2 zeigt eine Draufsicht auf einen Verdampferkörper gemäß einer zweiten Ausführungsform der Erfindung. Der Verdampferkörper 1 weist eine Verdampfungsfläche 3 mit zwei Vertiefungen 5' auf. Die Vertiefungen 5' haben jeweils eine kreisringförmige Öffnung und eine kreisringförmige Bodenfläche. Die Abmessungen des Verdampferkörpers 1 entsprechen denjenigen der ersten Ausführungsform. Der Außendurchmesser der jeweiligen Öffnung und Bodenfläche beträgt 30 mm, der jeweilige Innendurchmesser beträgt 18 mm. Daraus ergibt sich ein Fläche/Umfang-Verhältnis von 3 mm (=Ringbreite/2). Die Vertiefungen 5' haben jeweils eine Tiefe von 0,3 mm. Der Abstand der Vertiefungen 5' zueinander beträgt 25 mm.

Figur 3 zeigt eine Draufsicht auf einen Verdampferkörper gemäß einer dritten Ausführungsform der Erfindung. Die Verdampfungsfläche 3 des Verdampferkörpers 1 weist vier Vertiefungen 5'' auf. Die Öffnung und die Bodenfläche der jeweiligen Vertiefung 5'' haben die Form eines gleichschenkligen Dreieckrings. Die Vertiefungen 5'' sind derart angeordnet, dass die Hypotenuse eines jeden Dreieckrings im Wesentlichen senkrecht zur Längsachse/Symmetrieachse des Verdampferkörpers 1 steht. Die beiden inneren Vertiefungen 5'', d.h. die benachbart zur Längsmitte des Verdampferkörpers angeordneten Vertiefungen 5'' sind derart angeordnet, dass die Hypotenuse von der Längsmitte abgewandt ist. Die beiden äußeren Vertiefungen 5'' sind derart angeordnet, dass die Hypotenuse der Längsmitte zugewandt ist. Jeweils zwei Vertiefungen 5'' bilden eine Rautenform. Die Abmessungen des Verdampferkörpers 1. entsprechen denjenigen der ersten Ausführungsform. Die Hypotenuse hat eine Länge von 25 mm und eine Breite von 4 mm. Die Länge der beiden anderen Dreieckseiten kann je nach Bedarf eingestellt werden, so dass eine zweckmäßige Längen- und Breitenverteilung der Metallschmelze 9 erreicht wird. Im gezeigten Ausführungsbeispiel beträgt die Fläche der dreieckförmigen Öffnungen jeweils 148 mm², der Umfang jeweils 82,1 mm. Daraus ergibt sich ein Fläche/Umfang-Verhältnis von 1,8 mm. Die Vertiefungen 5 haben jeweils eine Tiefe von 0,3 mm. Der Abstand zwischen den beiden inneren Vertiefungen 5'' beträgt 25 mm, der jeweilige Abstand zwischen innerér und äußerer Vertiefung beträgt 5 mm.

In den gezeigten Ausführungsformen kann die Anzahl der Vertiefungen (ebenso wie die angegebene Größe bzw. das angegebene Fläche/Umfang-Verhältnis) je nach Bedarf verändert werden. Zudem ist es möglich verschiedene Formen miteinander zu kombinieren. Zum Beispiel können ausschließlich zwei innere dreieckförmige Vertiefungen vorgesehen werden oder zwei innere dreieckförmige Vertiefungen mit zwei äußeren kreisförmigen Vertiefungen kombiniert werden.

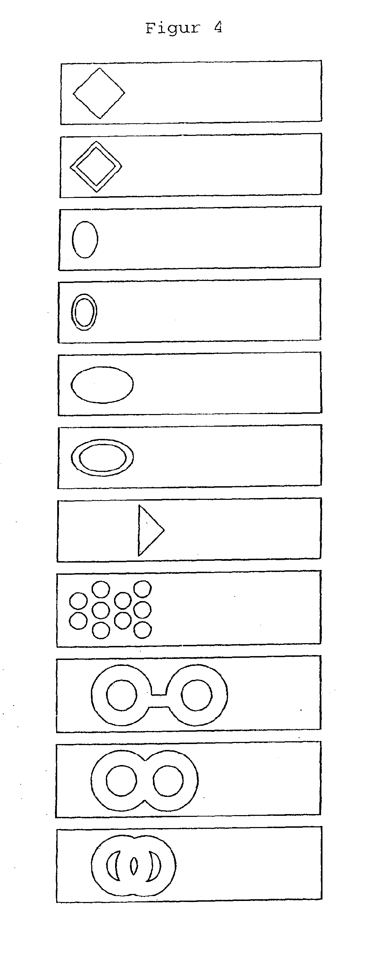

Figur 4 zeigt weitere Ausführungsbeispiele des erfindungsgemäßen Verdampferkörpers bzw. für die Form der Vertiefungsöffnung, wobei mit Ausnahme der letzten vier Beispiele zur Vereinfachung jeweils nur eine Vertiefung je Verdampferkörper dargestellt ist. Die unterschiedlichen in Figur 4 gezeigten Vertiefungsformen können selbstverständlich untereinander sowie mit den oben beschriebenen Formen kombiniert werden. Wie aus Figur 4 ersichtlich, kann die Öffnung der Vertiefung 5 z.B. eine elliptische Form oder die Form eines Ellipsenrings aufweisen. Die Hauptachse der Ellipse kann dabei z.B. senkrecht zu der Verdampferkörper-Längsachse sein. Alternativ kann sie jedoch auch zur Verdampferkörper-Längsachse parallel oder geneigt sein.

Wie in den drei untersten Beispielen von Figur 4 gezeigt können die mindestens zwei Vertiefungen z.B. über einen Verbindungskanal miteinander in Verbindung stehen oder sich teilweise überlappen/schneider. Zur Bestimmung des jeweiligen Fläche/Umfang-Verhältnisses kann dabei im Überlappungs-/Überschneidungsbereich einfach die Umfangslinie der jeweiligen Vertiefung/Öffnung symmetrisch weitergeführt werden. Überlappen die beiden Öffnungen, bilden sie eine Einschnürung oder Eindellung zwischen den beiden Vertiefungen/Öffnungen aus. Auch unterschiedlich geformte Öffnungen können sich überlappen.

Die geometrische Form der vertiefungen 5 bzw. der Öffnungen ist nicht auf die gezeigten Formen beschränkt. Vielmehr sind auch andere Formen/Öffnungen denkbar, welche ein Fläche/Umfang-Verhältnis von größer gleich 1,5 mm aufweisen und welche bei geeigneter Anordnung auf der Verdampfungsfläche 3 des Verdampferkörpers 1 eine zweckmäßige Benetzung des Verdampferkörpers ermöglichen.

Figur 5 zeigt die Vertiefung 5 eines erfindungsgemäßen Verdampferkörpers 1 im Detail. Die Seitenwand der Vertiefung 5 weist eine Krümmung 15 auf. Dadurch kann im Betrieb des Verdampferkörpers das Auftreten von Heißstellen in dem Bereich der Vertiefung 5 vermieden/reduziert werden.

Figur 6 zeigt die Vertiefung 5 eines erfindungsgemäßen Verdampferkörpers 1 im Detail. Die Seitenwand der Vertiefung 5 bildet mit dem an die Vertiefung 5 angrenzenden Teil der Verdampfungsfläche 3 einen Winkel von ungefähr 90°, wodurch das Aufstauen der Metallschmelze 9 an der Oberkante der Vertiefung 5 zu Beginn des Betriebs des Verdampferkörpers begünstigt wird.

## Patentansprüche

1. Elektrisch leitfähiger Verdampferkörper (1), der zum Verdampfen von Metall widerstandsbeheizbar ausgebildet ist und eine Verdampfungsfläche (3) zum Verdampfen des Metalls in einer PVD-Metallisierungsanlage aufweist, **dadurch gekennzeichnet**, daβ die Verdampfungsfläche (3) eine Mehrzahl von Vertiefungen (5, 5', 5'') aufweist, deren jeweilige Öffnung ein Fläche/Umfang-Verhältnis von größer gleich 1,5 mm aufweist.

2. Verdampferkörper (1) nach Anspruch 1, wobei die Verdampfungsfläche (3) eine Kavität (13) aufweist, in deren Bodenfläche die Mehrzahl von Vertiefungen (5, 5', 5'') ausgebildet ist.

3. Verdampferkörper (1) nach Anspruch 1 oder 2, wobei die Vertiefungen (5, 5', 5'') eine Tiefe von 0,05 bis 1 mm aufweisen.

4. Verdampferkörper (1) nach einem der vorangehenden Ansprüche, wobei die Seitenwand der jeweiligen Vertiefung (5, 5', 5'') mit dem an die Vertiefung (5, 5', 5'') angrenzenden Teil der Verdampfungsfläche (3) einen Winkel von 80 bis 150° bildet.

5. Verdampferkörper (1) nach einem der vorangehenden Ansprüche, wobei die Seitenwand der jeweiligen Vertiefung (5, 5', 5'') zumindest in dem an die Bodenfläche der Vertiefung (5, 5', 5'') angrenzenden Bereich gekrümmt ist.

6. Verdampferkörper (1) nach einem der vorangehenden Ansprüche, wobei eine oder mehrere oder alle der Öffnungen kreisförmig oder kreisringförmig sind.

7. Verdampferkörper (1) nach einem der vorangehenden Ansprüche, wobei eine oder mehrere oder alle der Öffnungen die Form einer Ellipse oder eines Ellipsenrings haben.

8. Verdampferkörper (1) nach einem der vorangehenden Ansprüche, wobei eine oder mehrere oder alle der Öffnungen als gleichseitiges Viereck oder als gleichseitiger Viereckring ausgebildet sind, wobei zwei der Eckpunkte auf der Längsachse des Verdampferkörpers (1) angeordnet sind.

9. Verdampferkörper (1) nach einem der vorangehenden Ansprüche, wobei eine oder mehrere oder alle der Öffnungen die Form eines gleichschenkligen Dreiecks oder eines gleichschenkligen Dreieckrings haben, und wobei die jeweilige Hypotenuse senkrecht zur Verdampferkörper-Längsachse angeordnet ist.

10. Verdampferkörper (1) nach einem der vorangehenden Ansprüche, wobei die Mehrzahl von Vertiefungen (5, 5', 5") in Verdampferkörper-Längsrichtung hintereinander angeordnet ist.

## Claims

1. Electrically conductive vaporizer body (1), which is formed so as to be resistively heatable for vaporizing metal and has a vaporizing surface (3) for vaporizing the metal in a PVD metallization installation, **characterized in that** the vaporizing surface (3) has a plurality of recesses (5, 5', 5''), the opening in each recess having an area/perimeter ratio of greater than or equal to 1.5 mm.

2. Vaporizer body (1) according to Claim 1, wherein the vaporizing surface (3) has a cavity (13), in the bottom surface of which the plurality of recesses (5, 5', 5'') are formed.

3. Vaporizer body (1) according to Claim 1 or 2, wherein the recesses (5, 5', 5'') have a depth of 0.05 to 1 mm.

4. Vaporizer body (1) according to one of the preceding claims, wherein the side wall of the respective recess (5, 5', 5'') forms an angle of 80 to 150° with that part of the vaporizing surface (3) which adjoins the recess (5, 5', 5'').

5. Vaporizer body (1) according to one of the preceding claims, wherein the side wall of the respective recess (5, 5', 5'') is curved at least in the region which adjoins the bottom surface of the recess (5, 5' , 5'').

6. Vaporizer body (1) according to one of the preceding claims, wherein one or more or all of the openings are circular or are shaped like a circular ring.

7. Vaporizer body (1) according to one of the preceding claims, wherein one or more or all of the openings have the form of an ellipse or an elliptical ring.

8. Vaporizer body (1) according to one of the preceding claims, wherein one or more or all of the openings are in the form of an equilateral quadrangle or of an equilateral quadrangle ring, wherein two of the corners are arranged on the longitudinal axis of the vaporizer body (1).

9. Vaporizer body (1) according to one of the preceding claims, wherein one or more or all of the openings have the form of an isosceles triangle or of an isosceles triangle ring, and wherein the respective hypotenuse is arranged perpendicular to the longitudinal axis of the vaporizer body.

10. Vaporizer body (1) according to one of the preceding claims, wherein the plurality of recesses (5, 5', 5'') are arranged in succession in the longitudinal direction of the vaporizer body.

## Revendications

1. Corps d'évaporateur (1) électriquement conducteur apte à être chauffé par résistance pour vaporiser du métal et présentant une surface de vaporisation (3) destinée à vaporiser le métal dans une installation de métallisation par PVD,
**caractérisé en ce que**
la surface de vaporisation (3) présente plusieurs creux (5, 5', 5'') dont l'ouverture présente un rapport surface/périphérie supérieur ou égal à 1,5 mm.

2. Corps d'évaporateur (1) selon la revendication 1, dans lequel la surface de vaporisation (3) présente une cavité (13) dont la surface de fond présente les différents creux (5, 5', 5'').

3. Corps d'évaporateur (1) selon les revendications 1 ou 2, dans lequel les creux (5, 5', 5") ont une profondeur de 0,05 à 1 mm.

4. Corps d'évaporateur (1) selon l'une des revendications précédentes, dans lequel la paroi latérale de chaque creux (5, 5', 5'') forme un angle de 80 à 150° avec la partie de la surface de vaporisation (3) adjacente aux creux (5, 5', 5'').

5. Corps d'évaporateur (1) selon l'une des revendications précédentes, dans lequel la paroi latérale de chaque creux (5, 5', 5'') est courbée au moins dans la partie adjacente à la surface de fond du creux (5, 5', 5'').

6. Corps d'évaporateur (1) selon l'une des revendications précédentes, dans lequel une, plusieurs ou toutes les ouvertures présentent la forme d'un cercle ou d'un anneau circulaire.

7. Corps d'évaporateur (1) selon l'une des revendications précédentes, dans lequel une, plusieurs ou toutes les ouvertures présentent la forme d'une ellipse ou d'un anneau elliptique.

8. Corps d'évaporateur (1) selon l'une des revendications précédentes, dans lequel une, plusieurs ou toutes les ouvertures sont configurées comme rectangle équilatéral ou comme anneau rectangulaire équilatéral dont deux des sommets sont disposés sur l'axe longitudinal du corps de vaporisation (1).

9. Corps d'évaporateur (1) selon l'une des revendications précédentes, dans lequel une, plusieurs ou toutes les ouvertures ont la forme d'un triangle équilatéral ou d'un anneau triangulaire équilatéral dont l'hypoténuse est disposée perpendiculairement à l'axe longitudinal du corps de vaporisation.

10. Corps d'évaporateur (1) selon l'une des revendications précédentes, dans lequel les différents creux (5, 5', 5'') sont disposés les uns derrière les autres dans le sens de la longueur du corps de vaporisation.
